# EUROPEAN PATENT APPLICATION

(11) **EP 2 031 657 A1**
(43) Date of publication of application: **04.03.2009**
(21) Application number: 07017145.9
(22) Date of filing: 31.08.2007
(51) Int. Cl.: H01L 25/075, H01L 33/00, F21K 7/00

(54) **Package structure for a high-luminance light source**

(71) Applicant: ILED Photoelectronics, Inc., Wugu Industry District Taiwan 24891 (CN)
(72) Inventor: Hsu, Chi-Yuan, Tapei County 24891 Taiwan (CN)
(74) Representative: Hauck Patent- und Rechtsanwälte

(57) **Abstract**

A package structure for a high-luminance light source comprises a circuit board, at least one light source, a resin coating covering the light source, and a fluorescent layer covering the resin coating. A light reflective layer is formed on a surface of the circuit board and is located correspondingly to the light source, and a plurality of reflective protrusions are disposed in a periphery of the light source. The light reflective layer is provided for reflecting the ineffective light of the light source, so as to turn the ineffective light into effective light. The reflective protrusions can reflect the horizontal ineffective light of the light source effectively, so that the light emitted at different angles from the light source are fully utilized to improve the luminescent efficiency of the light source.

## Description

### BACKGROUND OF THE INVENTION

### Field of the Invention

The present invention relates to a package structure for a light source, and more particularly to a package structure for a high-luminance light source which makes full use of the light emitted from the light source at different angles to reduce the requirements of the light source.

### Description of the Prior Art

Nowadays, conventional illumination lamps still have many disadvantages, for example, although incandescent lamps are cheap, they have the disadvantages of low luminescent efficiency, high electricity consumption, short life and are fragile. And fluorescent lamps can save energy, but the wasted fluorescent lamps have the problem of mercury pollution, short life and are fragile.

Relatively, the products of LED and cold light source which comply with the standard of energy saving and environment protection of various countries have the advantages of long life, low electricity consumption, pure light color, high shock resistance, miniaturization and are less likely to be broken.

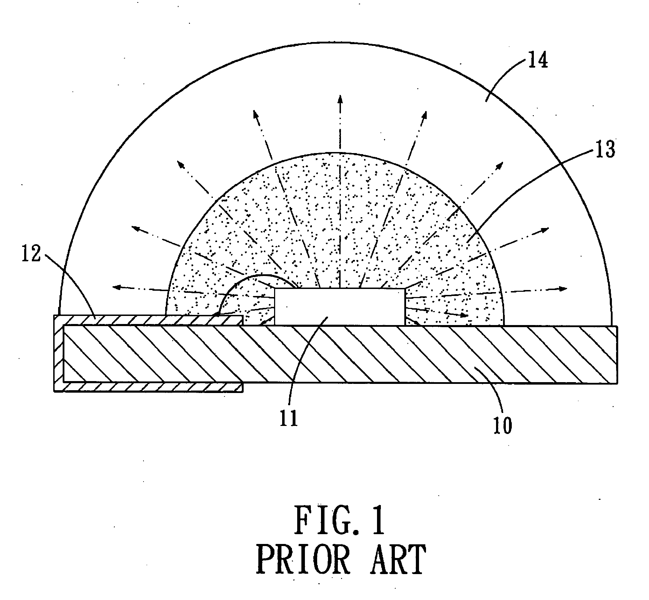

However, with the restriction of luminescent efficiency and the direction of the light, the above-mentioned products of LED and cold light source are still limited. With reference to Fig. 1, the products with LED light source have the following problems:
Firstly, a plurality of light emitting chips 11 is disposed on a circuit board 10 with a conductive layer 12, each light emitting chip 11 emits light in all directions and angles, and since the light emitted in the direction of the circuit board 10 by the light emitting chip 11 is ineffective, the luminescent efficiency (the effective rate of the emitted light) of the conventional LED and cold light source are too low. Such a design still can produce a luminance similar to the conventional bulbs, but it will waste a lot of energy. Thereby, finding a product with a high luminescent efficiency has become an important issue for the manufacturers and researchers.
Secondly, the conventional circuit board 10 usually uses a resin coating 13 to position and protect the light emitting chip 11, and a lens 14 is used to refract light. In addition, if the circuit board 10 is not defined with grooves or coatings to restrict the resin coating, the range of the resin coating 13 is difficult to control, and the cost of manufacturing such grooves or coatings is high.

The present invention has arisen to mitigate and/or obviate the afore-described disadvantages.

### SUMMARY OF THE INVENTION

The primary objective of the present invention is to provide a package structure for a high-luminance light source which uses the light emitted from the light source sufficiently.

To achieve the objective of the present invention, a light refractive layer is formed on a surface of a circuit board and is located correspondingly to the light source, and a plurality of refractive protrusions are disposed in a periphery of the light source. The light refractive layer can refract the ineffective light of the light source, so as to turn the ineffective light into effective light. The refractive protrusions can refract the horizontal ineffective light of the light source effectively, so that the light emitted at different angles from the light source are fully utilized to improve the luminescent efficiency of the light source.

The second objective of the present invention is to provide a package structure for a high-luminance light source which uses the high refractive effect of the horizontal light of the light source to reduce the quantity of the light source.

To achieve the objective of the present invention, in a periphery of each light source and between each two light sources are disposed refractive protrusions for refracting the horizontal ineffective light of the light sources effectively, such that the light can be supplemented sufficiently, and the refractive protrusions can reduce the quantity of the light sources by averaging the light intensity and utilizing the ineffective light.

The above-mentioned refractive protrusions disposed in the peripheries of the light sources can be formed by metal sputtering, electroplating or surface depositing, and can be synchronously formed with the light refractive layer by the same material.

In addition, the refractive protrusions disposed in the periphery of each light source or between each two light sources all can refract the horizontal ineffective light of the light source effectively.

The refractive protrusions can be semicircular-shaped, cone-shaped, rectangular-shaped, drop-shaped and so on, and all can refract the light according to different requirements.

It is to be noted that the light refractive layer with a smooth metal mirror of the present invention is formed by metal sputtering, electroplating or surface depositing, and the light refractive layer can be formed with an inclined light-guiding surface or an arc-shaped light-guiding surface correspondingly to the light source, so as to improve the luminescent efficiency of the present invention.

The present invention will become more obvious from the following description when taken in connection with the accompanying drawings, which show, for purpose of illustrations only, the preferred embodiments in accordance with the present invention.

### BRIEF DESCRIPTION OF THE DRAWINGS

Fig. 1 is an illustrative view showing a conventional package structure for a light source;
Fig. 2 is a perspective view of a circuit board and a light source in accordance with the present invention;
Fig. 3 is an assembly cross sectional view of the package structure for a high-luminance light source in accordance with the present invention; and
Fig. 4 is an illustrative view showing the refraction of the light source.

### DETAILED DESCRIPTION OF THE PREFERRED EMBODIMENTS

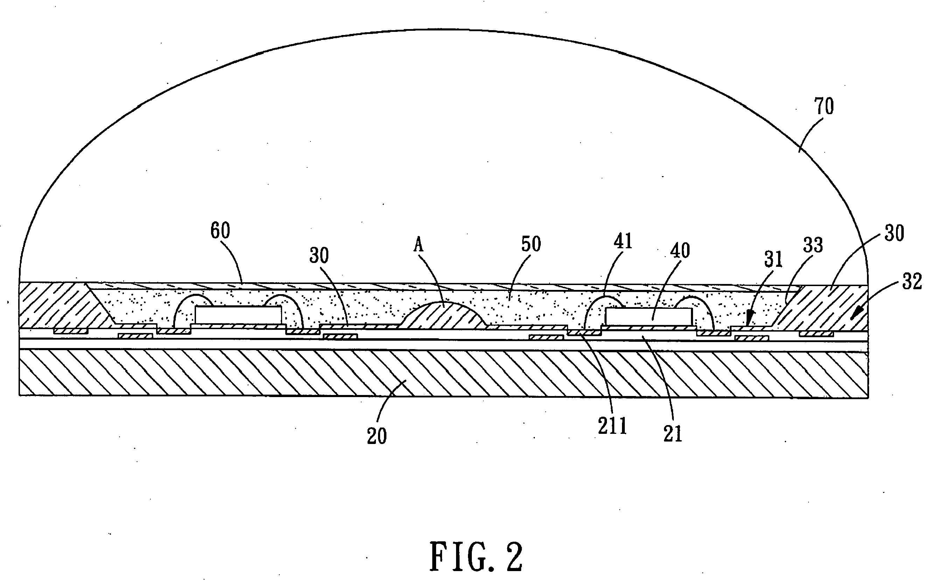

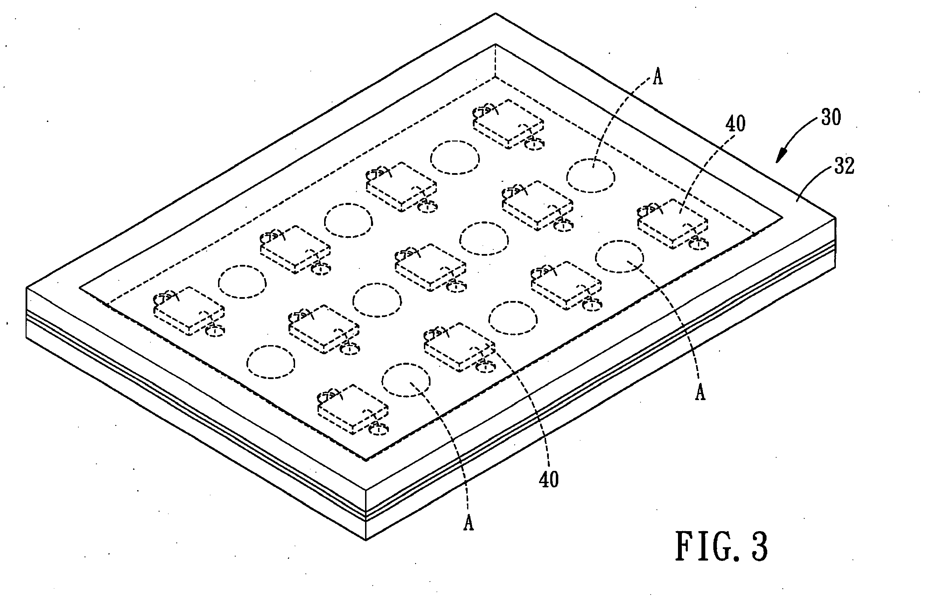

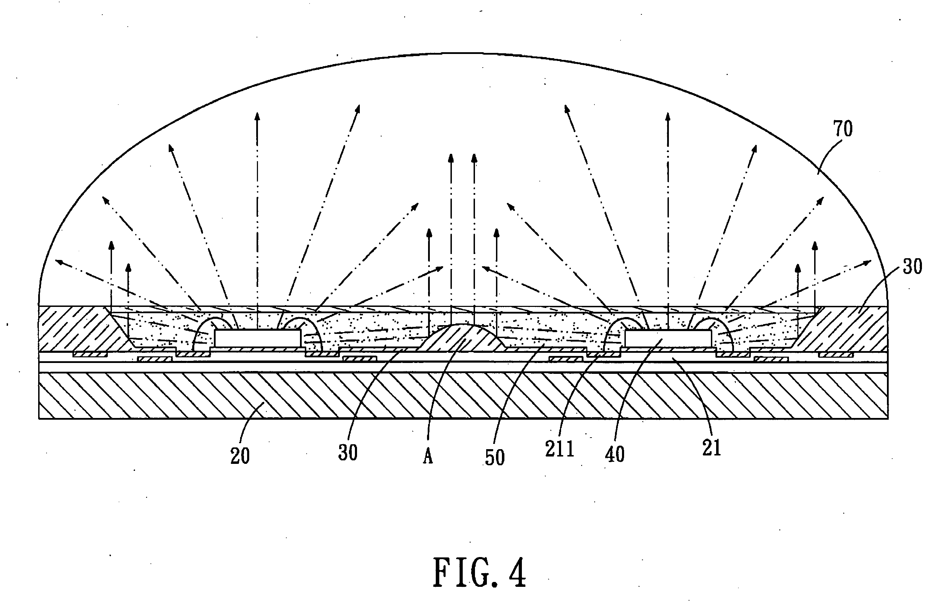

Referring to Figs. 2-4, a package structure for a high-luminance light source in accordance with the present invention comprises a circuit board 20, a light refractive layer 30, a plurality of refractive protrusions A, a plurality of light sources 40, a resin coating 50, a fluorescent layer 60, and a lens 70.

The circuit board 20 is formed with a printed circuit layer 21 with an electrode pad 211.

The light refractive layer 30 is a metallic layer protrusively formed on the surface of the circuit board 20 by the technique of metal sputtering, and the surface of the light refractive layer 30 is formed with a metal mirror 31. In addition, the sputtered light refractive layer 30 is protrusively formed with a stopping portion 32 located correspondingly to the electrode pad 211 of the circuit board 20, and the stopping portion 32 is formed with an inclined light-guiding surface 33 in the direction of the electrode pad 211.

The refractive protrusions A are made of the same material as the light refractive layer 30 and are formed on the surface of the circuit board 20 by the technique of metal sputtering. And the surfaces of the refractive protrusions A are also formed with metal mirrors. Moreover, the refractive protrusions A are semicircular-shaped and are located near the electrode pad 211 of the circuit board 20.

The light sources 40 are light emitting diodes (LED) and are located at the light refractive layer 30. Each light source 40 is fixed correspondingly to the electrode pad 211 of the circuit board 20 and is electrically connected to the electrode pad 211 of the circuit board 20 by a bonding wire 41. And between each two light sources 40 is disposed a refractive protrusion A.

The resin coating 50 covers the light sources 40 and the bonding wires 41 and is restricted in the stopping portion 32 protrusively formed on the light refractive layer 30.

The fluorescent layer 60 covers the resin coating 50, the lens 70 covers the fluorescent layer 60 and cooperates with the fluorescent layer 60 to refract the light emitted from the light sources 40 effectively.

For a better understanding of the present invention, its operations and functions, reference should be made to Figs. 2-4 again:
When in use, since the light refractive layer 30 is formed on the surface of the circuit board 20, the surface of the light refractive layer 30 is formed with a metal mirror 31, and the stopping portion 32 is formed with an inclined light-guiding surface 33 in the direction of the electrode pad 211, when the light source 40 is activated to emit light, the light will be emitted through the resin coating 50 and the lens 60. Thereby, the present invention has the same luminescent efficiency as the conventional structure.

In addition, the light emitted from the light sources 40 in the direction of the light refractive layer 30 will be refracted by the metal mirror 31 of the light refractive layer 30, and the horizontal light will be refracted by the inclined light-guiding surface 33 of the stopping portion 32. Thereby, the present invention can effectively refract the light of the light sources 40 in all directions, so as to produce a better luminescent efficiency than the conventional structure.

The key point is that between each two light sources 40 is disposed a refractive protrusion A that is made of the same material as the light refractive layer 30 (the surface of the refractive protrusion A also formed with a metal mirror). Thereby, the protruded semicircular-shaped refractive protrusion A can refract the horizontal light between each two light sources 40 effectively, and the moonlight phenomenon produced by reflecting the solar light by the moon will be produced. By such arrangements, in addition to the light sources 40 on the circuit board 20, the plurality of refractive protrusions A can also be used to refract light.

It is apparent from the above-mentioned descriptions that all the light of the light sources 40, whatever it is emitted in the horizontal direction or toward the bottom thereof, or light the horizontal light between each two light sources 40, can be refracted effectively to improve the luminescent efficiency of the light source.

In particular, each refractive protrusion A can emit light, so that in addition to the light sources 40 on the circuit board 20, the plurality of refractive protrusions A can refract light out. Such arrangements not only can increase the light to supplement light evenly, but also can reduce the quantity of the light sources 40 by the products of same area and same requirements of light intensity, thus reducing the cost.

In a word, the present invention is characterized in that:
Firstly, the light refractive layer is formed on the surface of the circuit board and is located correspondingly to the light sources, and the plurality of refractive protrusions are disposed in peripheries of the light sources. The light refractive layer cooperates with the refractive protrusions to refract the ineffective light of the light sources, so as to turn the ineffective light into effective light, so that the light emitted at different angles from the light sources are fully utilized to improve the luminescent efficiency of the light sources.

Secondly, each refractive protrusion can refract light, so that in addition to the light sources on the circuit board, the plurality of refractive protrusions can refract light out, so as to reduce the quantity of the light sources by the products of same area and same requirements of light intensity, thus reducing the cost.

To summarize, a package structure for a high-luminance light source in accordance with the present invention comprises a circuit board, at least one light source, a resin coating covering the light source and a fluorescent layer covering the resin coating, and is characterized in that: the light refractive layer is formed on the surface of the circuit board and is located correspondingly to the light source, and the plurality of refractive protrusions are disposed in the periphery of the light source. The light refractive layer can refract the ineffective light of the light source, so as to turn the ineffective light into effective light. The refractive protrusions can refract the horizontal ineffective light of the light source effectively, so that the light emitted at different angles from the light source are fully utilized to reduce the requirements of the light source and to improve the luminescent efficiency of the light source.

While we have shown and described various embodiments in accordance with the present invention, it should be clear to those skilled in the art that further embodiments may be made without departing from the scope of the present invention.

## Claims

1. A package structure for a high-luminance light source, comprising:
a circuit board;
at least one light source mounted on the circuit board;
at least one refractive protrusion located near the light source for refracting a horizontal light of the light source; and
a resin coating for covering the light source and the refractive protrusion.

2. The package structure for a high-luminance light source as claimed in claim 1 further comprising a light refractive layer, wherein:
the circuit board is disposed with a printed circuit layer with an electrode pad;
the light refractive layer is a metallic layer formed with a metal mirror on a surface thereof, and
the refractive protrusion made of a same material as the light refractive layer is formed with a metal mirror on a surface thereof and is formed on the surface of the circuit board.

3. The package structure for a high-luminance light source as claimed in claim 2 further comprising a fluorescent layer and a lens, wherein:
the circuit board is disposed with a printed circuit layer with an electrode pad;
the light refractive layer is protrusively formed with a stopping portion located correspondingly to the electrode pad of the circuit board;
the light source is located at the light refractive layer, the light source is fixed correspondingly to the electrode pad of the circuit board and is electrically connected to the electrode pad of the circuit board by a bonding wire;
the resin coating is provided for covering the light source and the bonding wire and is restricted in the stopping portion of the light refractive layer; and
the lens is located outside the light source and the bonding wire and is provided for covering the resin coating, so as to effectively refract the light emitted from the light source.

4. The package structure for a high-luminance light source as claimed in claim 1 comprising a plurality of light sources, wherein the refractive protrusion is located between the light sources.

5. The package structure for a high-luminance light source as claimed in claim 1, wherein the refractive protrusion is semicircular-shaped, or cone-shaped, or rectangular-shaped, or drop-shaped.

6. A package structure for a high-luminance light source, comprising:
a circuit board disposed with a printed circuit layer with an electrode pad;
a light refractive layer being a metallic layer formed on a surface of the circuit board and formed with a metal mirror on a surface thereof,
a plurality of refractive protrusions formed on the surface of the circuit board and located near the electrode pad of the circuit board for refracting light;
a plurality of light sources located on the light refractive layer and electrically connected to the electrode pad of the circuit board by bonding wires, between each two light sources being formed one refractive protrusion;
a resin coating covering the light sources and the bonding wires;
a fluorescent layer covering the resin coating; and
a lens covering the fluorescent layer.

7. The package structure for a high-luminance light source as claimed in claim 6, wherein: the refractive protrusion is semicircular-shaped, or cone-shaped, or rectangular-shaped, or drop-shaped.

8. The package structure for a high-luminance light source as claimed in claim 6, wherein the light sources are light emitting diodes (LED).
